(19) Europäisches Patentamt
European Patent Office
Office européen des brevets

(11) Numéro de publication : **0 124 452**
**B1**

# (12) FASCICULE DE BREVET EUROPÉEN

(45) Date de publication du fascicule du brevet : **02.03.88**

(51) Int. Cl.[4] : **C 25 D 5/56**

(21) Numéro de dépôt : **84420061.8**

(22) Date de dépôt : **03.04.84**

## (54) Procédé de métallisation de films souples électriquement isolants et articles obtenus.

(30) Priorité : **15.04.83 FR 8306405**

(43) Date de publication de la demande :
**07.11.84 Bulletin 84/45**

(45) Mention de la délivrance du brevet :
**02.03.88 Bulletin 88/09**

(84) Etats contractants désignés :
**AT BE CH DE FR GB IT LI LU NL SE**

(56) Documents cités :
**EP-A- 0 082 904**
**EP-A- 0 126 014**
**DE-A- 2 623 695**
**FR-A- 1 469 798**
**FR-A- 1 524 702**
**FR-A- 2 518 126**
**KIRK OTHMER "Encyclopedy of Chemical Technology", 3rd ed., vol. 10, p. 216**

(73) Titulaire : **RHONE-POULENC CHIMIE**
**25, quai Paul Doumer**
**F-92408 Courbevoie Cédex (FR)**

(72) Inventeur : **Alliot-Lugaz, Maurice**
**34 Rue Baraban**
**F-69003 Lyon (FR)**
Inventeur : **Cassat, Robert**
**Chemin de Crapon**
**F-69360 Ternay (FR)**

(74) Mandataire : **Varnière-Grange, Monique et al**
**RHONE-POULENC INTERSERVICES Service Brevets Chimie Centre de Recherches de Saint-Fons B.P. 62**
**F-69192 Saint-Fons Cédex (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

**EP 0 124 452 B1**

Jouve, 18, rue St-Denis, 75001 Paris, France

**Description**

Le développement incomparable de l'électronique dans tous les domaines de la vie courante comme dans les domaines industriels de pointe est la cause de très nombreuses recherches pour miniaturiser ou pour rendre sans cesse moins onéreux les différents constituants nécessaires.

La présente invention a pour objet un procédé de métallisation de films électriquement isolants en matière plastique. Elle concerne également les produits intermédiaires et les produits finis qui ont été fabriqués par ce procédé. La présente invention a trait plus particulièrement à un procédé permettant d'appliquer des dépôts métalliques très adhérents et ductiles sur des films souples en faisant appel de préférence à des moyens électrolytiques mais aussi éventuellement à des moyens chimiques.

Les films souples sont abondamment utilisés aussi bien comme support de circuiterie (circuits imprimés) que comme constituant de systèmes électroniques. Il est alors nécessaire de pouvoir obtenir aussi bien en surface que dans l'épaisseur des zones bien délimitées ayant soit des propriétés conductrices soit des propriétés isolantes électriquement.

Après avoir utilisé pendant longtemps des substrats rigides de type papier enduit de bakélite puis de résines phénoliques ou de résines époxy, on s'oriente maintenant vers des substrats souples en polymères thermoplastiques ou thermodurcissables filmogènes. On choisira ces polymères selon les usages et les impératifs retenus, par exemple :

Polytéréphtalate d'éthylèneglycol, polypropylène, polyacétal si l'on ne cherche pas de haute tenue en température, polymères fluorés, polyéthersulfone, polyétherimide, polyphénylènesulfure, polyphénylène oxyde modifié, polyarylate, polybenzimidazole, polyimides amides, polyimides ou polyamides aromatiques si l'on cherche une bonne tenue en température.

De très nombreux procédés ont été décrits dans la littérature pour métalliser un film de matière plastique en surface. Nous passerons rapidement sur les procédés qui mettent en œuvre le contrecollage par divers moyens, de pellicules métalliques sur le film plastique, et sur les procédés mettant en œuvre des dépôts conducteurs ou isolants constitués d'un liant qui adhère au support et d'un composé minéral isolant ou conducteur électrique.

Nous signalerons toutefois le procédé P 25 de Philips décrit dans « Electronic Production » Décembre 1973 page 8 qui est bien représentatif de l'art antérieur. Il fait appel à un procédé de réduction du palladium.

L'originalité réside dans la sensibilisation de $TiO_2$ dispersé dans la masse du film par la lumière (rayonnement de 365 nm) et la réduction du chlorure de palladium en palladium métallique. En un second temps il est nécessaire de renforcer par un procédé chimique, la couche métallique de surface. Ce procédé présente donc l'inconvénient de ne pouvoir agir qu'en surface et d'autre part nécessite l'emploi d'un procédé chimique de métallisation.

Parmi les autres procédés on retiendra celui décrit dans le brevet US-P-3 767 538 qui consiste à rendre rugueuse la surface de film polyester ou polyimide par traitement chimique, à y créer des germes conducteurs en palladium, à y déposer par méthode chimique ou évaporation une couche d'argent qui sera ultérieurement renforcée par procédé chimique. On remarquera que ce procédé est long et coûteux.

La demande antérieure EP-A-0 082 094 publiée le 22 juin 1983, désignant les états contractants BE, DE, GB, IT, NL et SE et étant pour ces états comprises dans l'état de la technique, conformément à l'article 54 (3) et (4) de la CBE, a trait à un procédé de métallisation de supports souples ou rigides, électriquement isolants par mise en forme d'un mélange de polymère et de particules d'oxyde cuivreux, suivi d'un décapage superficiel et d'une réduction de l'oxyde cuivreux en cuivre métallique avec une solution aqueuse de borohydrure de sodium pour obtenir une surface conductrice d'électricité sur laquelle on procède alors à un cuivrage électrolytique. Ledit mélange peut être mis en forme, par exemple par compression, simple coulée à chaud, d'extrusion, selon sa consistance.

Les substrats métallisés obtenus peuvent entrer dans le domaine de nombreuses industries, pour la fabrication de circuits imprimés ou de filaments conducteurs par exemple.

Les polymères mis en œuvre peuvent être des élastomères, des polymères thermoplastiques ou thermodurcissables, et selon les exemples, des polyimides pressés sous forme de plaquette de 2 mm d'épaisseur ou moulés, une résine époxy moulée ou un polyamide sous forme de filaments pour constituer un câble.

La nécessité se faisait sentir de mettre au point une technique pour la réalisation de films supports pour l'industrie électronique visant à réaliser les objectifs suivants :

— réduction importante des coûts de production (tracé, perçage, ébavurage),
— amélioration de la qualité des circuits finis,
— augmentation de la densité d'interconnexion,
— respect des normes de plus en plus sévères de pollution.

Il était nécessaire que le nouveau procédé soit adapté à la réalisation de la circuiterie plane rigide ou souple et des trous métallisés. Il fallait aussi que le dépôt métallique soit de bonne qualité : adhérence au support — cohérence du dépôt et rapport des dépôts dans les trous par rapport au dépôt plan, supérieur ou égal à 1.

Il a été maintenant trouvé et c'est ce qui constitue l'un des objets de la présente invention un procédé

permettant de rendre conductrices des zones bien déterminées, qui peuvent être renforcées directement si nécessaire par un procédé électrolytique. On a ainsi surmonté l'obstacle de l'emploi de la métallisation par voie chimique sans courant qui est une méthode lente dont la vitesse de dépôt est de l'ordre de un micron par heure, et perd donc tout son intérêt quand il s'agit d'obtenir des couches métalliques dont l'épaisseur va dépasser vingt microns. Pour obtenir de pareilles couches épaisses, on procède en général d'abord à un dépôt chimique sans courant de l'ordre de quelques microns par exemple, puis on effectue ensuite un second dépôt par voie électrolytique. La voie électrolytique est incomparablement plus rapide, puisque sa vitesse de dépôt est de l'ordre de cinquante à cent microns par heure.

Un autre objet de l'invention est la réalisation de films souples polymériques qui peuvent être revêtus d'une couche de cuivre ayant une épaisseur de l'ordre du micron. Cette couche, dont la résistivité superficielle est comprise entre 0,01 Ω/□ et $10^3$ Ω/□, suffit à rendre conducteur de l'électricité le film. De plus étant ancrée dans le film lui-même, elle est de ce fait très cohérente avec lui. On peut déposer ultérieurement des couches métalliques plus épaisses dont l'adhérence est excellente. On peut aussi par l'emploi de surcouches minces en métal fondant à basse température rendre soudable de tels films.

Il a été trouvé un procédé de métallisation de films souples électriquement isolants en polymères filmogènes thermoplastiques ou ayant une phase thermoplastique, non thermodurcissables, caractérisé par les étapes suivantes :

1. On prépare un mélange homogène du polymère filmogène avec de 10 à 70 % en poids par rapport à la composition totale d'oxyde cuivreux sous forme de particules éventuellement en présence d'un solvant et de divers adjuvants.
2. On forme un film soit par extrusion soit par coulée à partir de ce mélange.
3. On met à jour, si besoin est, sur au moins une portion de la surface du film les grains d'oxyde cuivreux.
4. On réduit l'oxyde cuivreux en cuivre métallique par traitement avec un borohydrure d'au moins une portion de la surface du film pour la rendre conductrice de l'électricité.
5. On renforce ladite surface, éventuellement par voie électrolytique.

Par l'emploi de tels films on peut réaliser des circuits imprimés par les étapes suivantes :

a) enduction par un photorésist du film réduit éventuellement renforcé électrolytiquement
b) développement du photorésist
c) renforcement électrolytique direct
d) élimination du photorésist
e) gravure non sélective.

Par polymère thermoplastique ou ayant une phase thermoplastique on entend essentiellement des polymères naturels ou synthétiques. Parmi les polymères naturels convenant à la mise en œuvre de la présente invention, on peut citer les polymères cellulosiques tels :

— la cellulose régénérée
— l'éthylcellulose
— l'acétate de cellulose
— le triacétate de cellulose
— l'acétobutyrate de cellulose
— le propionate de cellulose
— le nitrate de cellulose
— la nitrocellulose.

Parmi les polymères synthétiques convenant à la mise en œuvre de la présente invention on peut citer :

— les polyoléfines et notamment :
  — le polyéthylène
  — le polypropylène et leurs copolymères
  — les copolymères de polyéthylène et d'acétate de vinyle
  — le polybutylène
  — le polyisobutylène
  — le polyéthylène chlorosulfoné
  — le polybutène
  — le polyméthylpentène
  — le polyparaxylylène
— les polymères de type polyvinylique :
  — le polychlorure de vinyle
  — le polychlorure de vinylidène
  — l'alcol polyvinylique
  — les polybutyrates
— les polymères de type polyacrylique :
  — les poly(méth)acrylates,
  — le polyéthylène éthyl acrylate
  — le polyméthylméthacrylate
  — le polyacrylonitrile

— le polystyrène acrylonitrile
— les polymères de type polystyrénique :
— le polystyrène poly-alpha-méthylstyrène
— les copolymères acrylique-butadiène-styrène ou butadiène-styrène
— les polyacétals
— les polymères fluorés :
— le polyéthylène propylène fluoré
— le polychlorotrifluoro éthylène
— le polytétrafluoroéthylène
— le polyparafluoroalcoxy
— le polyfluorure de vinyle
— le polyfluorure de vinylidène
— les élastomères tels :
— les polyuréthanes
— les silicones
— le polychloroprène
— le polyisoprène hydrochloré
— les polyamides :
— Nylon 6
— Nylon 6-6
— Nylon 11
— Nylon 12 et leurs copolyamides
— les polycarbonates
— les polyesters saturés et leurs copolyesters :
— le polytéréphtalate d'éthylène glycol
— le polytéréphtalate de butylène glycol
— le polyoxyde de phénylène, modifié ou non
— la polysulfone
— la polyéthersulfone
— la polyphénylène sulfone ou le polyphénylène sulfure ou divers autres polymères comme les polyhydantoïnes, les polyparabanique acides ou les polyéthylène oxydes.

Ces polymères peuvent être transformés en films et pellicules essentiellement par extrusion de la matière fondue ou par coulée de solutions. D'autres techniques comme le calandrage ou frittage peuvent éventuellement être utilisées dans des cas bien particuliers.

On utilise une quantité d'oxyde cuivreux comprise entre 10 et 70 % en poids du sec de la composition totale et de préférence entre 30 et 50 %.

Cet oxyde doit se présenter sous la forme de particules de très petites dimensions. La granulométrie est en général comprise entre 0,1 et 5 microns.

On peut ajouter à la composition des additifs du type de ceux utilisés pour les peintures dans le but d'améliorer la mise en suspension de l'oxyde et de stabiliser cette suspension. Des agents mouillants, des colloïdes protecteurs, des émulsifiants, des agents glissants peuvent aussi être utilisés à condition qu'ils ne modifient pas la résistivité des collodions, des compositions fondues et des films obtenus.

Lors de la préparation des collodions, on dissout en un premier temps le polymère dans un solvant approprié jusqu'à obtenir une solution. On ajoute ensuite l'oxyde métallique.

La solution de polymère chargée d'oxyde cuivreux est ensuite traitée par des moyens analogues à ceux utilisés pour la préparation des peintures : turbines du type Rayneri à grande vitesse de rotation, passages successifs sur des appareils de type tricylindre ou monocylindre sur barre par exemple.

Le but de ce traitement est de diviser au maximum les agglomérats d'oxyde cuivreux et de les disperser en grain unitaire.

Si l'on opère par extrusion, on prépare le mélange à sec en homogénéisant au maximum le mélange des poudres avec éventuellement les adjuvants nécessaires.

Un broyage avant mélange des composants ou après mélange peut être nécessaire pour obtenir des poudres très fines ne présentant pas d'agrégats.

Le film est ensuite conformé par coulée ou extrusion selon les techniques habituelles.

Le plus souvent on est amené en pratique à réaliser ensuite un étirage du film ou un biétirage pour donner des caractéristiques mécaniques au film. On a constaté que ce traitement suffisait pour mettre à jour les grains d'oxyde métallique et les débarrasser de la pellicule qui pouvait les recouvrir, sans avoir recours à un traitement superficiel de décapage (sablage, rouleaux abrasifs, tranchage ... ou traitement chimique).

Dans certains cas toutefois, on désire mettre en œuvre un film non étiré et il peut alors s'avérer nécessaire de mettre à jour les grains d'oxyde par un traitement superficiel de décapage comme indiqué ci-avant.

Le film pourra alors, suivant les besoins, subir un traitement de stabilisation thermique et/ou être perforé selon un schéma préétabli si le film est destiné à la fabrication de circuits à trous traversants.

La résistivité superficielle du film que l'on veut obtenir avant renforcement par électrolyse dépend du

taux d'oxyde métallique mais aussi de l'importance de la réduction opérée. On a trouvé que la surface du film avant renforcement électrolytique présente avantageusement une résistivité superficielle comprise entre 0,01 Ω/□ et environ $10^3$ Ω/□.

On a constaté que la transformation de l'oxyde cuivreux en cuivre métallique peut être conduite facilement et de manière quantitative par action des borohydrures. La transformation est représentée par la réaction :

$$_4Cu_2O + BH_4^- \dashrightarrow {}_8Cu + B(OH)_3 + OH^-$$

Cette facilité de réaction est probablement due à l'effet catalytique du cuivre métal qui pourrait s'expliquer par la formation intermédiaire d'hydrure de cuivre instable.

Les borohydrures utilisables dans la présente invention englobent des borohydrures substitués aussi bien que des borohydrures non substitués. Des borohydrures substitués dans lesquels au plus trois atomes d'hydrogène de l'ion borohydrure ont été remplacés par des substituants inertes dans les conditions de réduction comme par exemple des radicaux alkyles, des radicaux aryles, des radicaux alkoxy peuvent être utilisés. On fait appel de préférence à des borohydrures alcalins dans lesquels la partie alcaline consiste en du sodium ou du potassium. Des exemples typiques de composés qui conviennent sont : le borohydrure de sodium, le borohydrure de potassium, le diéthylborohydrure de sodium, le triméthoxyborohydrure de sodium, le triphénylborohydrure de potassium.

Le traitement réducteur est conduit de manière simple par mise en contact du film avec une solution de borohydrure dans l'eau ou dans un mélange d'eau et d'un solvant polaire inerte comme par exemple un alcool aliphatique inférieur. On donne la préférence aux solutions purement aqueuses de borohydrure. La concentration de ces solutions peut varier dans de larges limites et elle se situe de préférence entre 0,05 et 1 % en poids d'hydrogène actif du borohydrure par rapport à la solution. Le traitement réducteur peut être effectué à température élevée, cependant on préfère le mettre en œuvre à une température voisine de la température ambiante, par exemple entre 15 °C et 30 °C. A propos du déroulement de la réaction, il faut noter qu'elle donne naissance à du $B(OH)_3$ et à des ions $OH^-$ qui ont pour effet d'induire une augmentation du pH du milieu au cours de la réduction. Or à des valeurs de pH élevées, par exemple supérieures à 13, la réduction est ralentie de sorte qu'il peut être avantageux d'opérer dans un milieu tamponné pour avoir une vitesse de réduction bien déterminée. Après réduction on rince le film.

En début de réduction, la réaction concerne essentiellement les grains d'oxyde cuivreux qui se trouvent en surface du substrat et qui sont en contact direct avec l'agent réducteur. Du fait de l'effet catalytique du cuivre métal, la réaction de réduction va se poursuivre ensuite dans l'épaisseur du film et ceci bien que les résines utilisées ne présentent pas un caractère hydrophile particulièrement marqué. C'est dont en jouant principalement sur la durée du traitement qu'il est possible de contrôler aisément l'importance de la réduction opérée. Pour obtenir une résistivité répondant aux valeurs souhaitées, la durée du traitement qui est nécessaire est en général assez courte et, selon les proportions d'oxyde compris dans le substrat, elle se situe habituellement entre environ une minute et une quinzaine de minutes. Pour une durée de traitement donnée, il est possible d'agir encore sur la vitesse de réduction en ajoutant dans le milieu des accélérateurs variés comme par exemple de l'acide borique, de l'acide oxalique, de l'acide citrique, de l'acide tartrique ou des chlorures de métaux tels que le chlorure de cobalt-II, de nickel-II, de fer-II, de manganèse-II, de cuivre-II.

La réduction qui est opérée dans l'intervalle de temps indiqué ci-avant concerne une partie seulement de l'épaisseur du film. A noter que pour des applications électriques, on veille à ne réduire qu'une partie seulement de l'épaisseur du film afin de conserver une partie interne non réduite, isolante pour éviter tout phénomène parasite de pontage conducteur. Par contre s'il a été prévu des trous, on constate qu'une couche, au minimum de même épaisseur qu'en surface est aussi réduite sur le pourtour des trous.

Etant donné l'état très divisé du cuivre obtenu après le traitement réducteur, on devait s'attendre à ce que son oxydation à l'air soit rapide. Or on a constaté qu'il n'en est rien et que le niveau de la résistivité superficielle du film après réduction n'évolue pas pendant plusieurs jours de conservation à l'air ambiant.

Il est donc possible de stocker dans cet état le film réduit. On peut prévoir à titre de précaution soit un rinçage incomplet laissant des traces de réducteur à la surface du film, soit l'addition au bain de rinçage d'un agent réducteur particulier par exemple d'hydroquinone soit la protection du film rincé et séché par enduction d'un film protecteur par exemple de photorésist.

Le film réduit peut ensuite être métallisé par dépôt d'une couche de cuivre, de nickel ou d'un autre métal. Cette métallisation peut être faite par voie chimique sans courant, mais il a été constaté et ceci constitue un des avantages essentiels liés à la mise en œuvre de la présente invention, qu'elle peut être faite aussi directement par voie électrolytique. Dans certaines applications, il n'est pas rare de rechercher un dépôt de couche métallique d'au moins 20 microns, aussi la possibilité de pouvoir utiliser directement la voie électrolytique correspond-elle vraiment à un procédé industriellement rentable. Il est possible bien entendu de procéder, de manière classique, d'abord à une métallisation chimique, puis de renforcer ce premier dépôt par un dépôt ultérieur électrolytique. Pour avoir une description détaillée des conditions opératoires propres à la métallisation chimique, on peut se reporter à l'ouvrage « Encyclopedia of Polymer Science and Technology, 1968, volume 8, pages 658 à 661 ». Les proportions des constituants du

bain chimique, la durée de l'immersion du film, la température et les autres conditions opératoires sont déterminées dans chaque cas particulier de manière connue en soi pour obtenir les meilleurs résultats.

La métallisation par électrolyse est bien connue ; cf. notamment « Encyclopedia of Polymer Science and Technology, 1968, volume 8, pages 661 à 663 ». Le film convenablement réduit constitue la cathode et le métal à déposer l'anode. Tous deux sont immergés dans un électrolyte traversé par un courant. Par exemple dans le cas d'un cuivrage électrolytique, le métal déposé peut procéder du cuivre monovalent ou bivalent et provenir d'un électrolyte cyanuré (cuivre monovalent) ou d'un électrolyte à base de sulfate, pyrophosphate ou fluoborate (cuivre bivalent). Plusieurs adjuvants peuvent être ajoutés dans l'électrolyte : un sel alcalin ou alcalino-terreux, un acide (bain de cuivrage acide au sulfate de cuivre) ou une base (bain d'étamage alcalin au stannate) pour augmenter la conductivité de l'électrolyte ; un agent tampon pour éviter les variations rapides du pH ; des corps modifiant la structure des électrodépôts comme par exemple les colloïdes, des agents tensio-actifs, un phénol, un phénol sulfoné, un brillanteur minéral ou organique, un agent nivelant tel que par exemple la coumarine. La qualité de l'électrodépôt, qu'il soit d'un métal ou d'un alliage métallique, va dépendre de la composition de l'électrolyte et des conditions physiques de l'électrolyse (température, densité de courant cathodique et anodique, distance anode-cathode, conditionnement superficiel des électrodes, etc.) ; le réglage de ces différents paramètres sera fait dans chaque cas particulier de manière connue en soi.

Le fait de pouvoir propager la réduction dans l'épaisseur du film va permettre d'engendrer les avantages suivants : lors de la métallisation, il y aura un ancrage profond du métal déposé dans le substrat résineux ; dans le cas d'une soudure avec un apport de métal formant un alliage, l'alliage pourra migrer également à l'intérieur du substrat puisqu'il y a une réelle continuité du cuivre dans l'épaisseur du substrat ; dans le cas d'une métallisation destinée à jouer le rôle de drain thermique, il sera possible d'agir sur le transfert thermique de la résine en faisant progresser plus ou moins la réduction dans la masse du film.

Selon la durée du traitement électrolytique on pourra obtenir des couches métalliques dont l'épaisseur est supérieure ou égale à 1 micron, couches enracinées dans le film et présentant une bonne cohésion, contrairement à ce qui ce passe avec des dépôts par voie chimique sans courant. Des films comportant une couche de cuivre aussi mince que 1 micron d'épaisseur présentent un grand intérêt pour la réalisation de circuits imprimés, car ils permettent lors des traitements ultérieurs de gravure de supprimer les défauts et notamment la sous-gravure. On peut ainsi augmenter la densité de la circuiterie et augmenter la fiabilité des circuits.

Il va de soi que l'on peut obtenir aussi des dépôts métalliques beaucoup plus importants, de l'ordre de 20 à 50 microns par exemple, dépôts correspondant aux techniques actuellement utilisées pour la réalisation de circuits imprimés. On peut de même déposer par fusion ou par voie électrolytique des couches d'alliages de type plomb/étain.

La réalisation de circuits imprimés à partir de films réduits peut alors se faire selon les procédés additifs classiques et la réalisation de circuits à partir de films réduits et métallisés par voie électrolytique, par gravure classique.

Schématiquement, pour l'obtention de circuits à trous traversants on peut indiquer brièvement deux méthodes possibles. La première méthode « Pattern plating » consiste en partant du film préparé selon l'invention à percer des trous aux emplacements prévus et selon le mode de perçage à dépoussiérer puis à appliquer le photorésist, à le développer puis à réduire l'oxyde cuivreux selon l'invention. Après un rinçage à l'eau on opère une métallisation chimique, on rince puis on élimine le photorésist, on rince et on sèche.

Des variantes peuvent être apportées à cette méthode qui sera de toute façon lente à cause de la phase de métallisation chimique.

La deuxième méthode industriellement beaucoup plus intéressante ou « Panel plating » consiste en partant du film préparé selon l'invention à percer des trous aux emplacements prévus, éventuellement à dépoussiérer puis à réduire l'oxyde cuivreux selon l'invention, à rincer à l'eau, à appliquer le photorésist, à le développer puis à métalliser par voie électrolytique. Après rinçage on élimine le photorésist puis on effectue la gravure non sélective. On rince puis on sèche.

Cette méthode qui comporte une phase de plus que la méthode précédente est en réalité beaucoup plus rapide puisque la métallisation par voie électrolytique peut être 100 fois plus rapide que par voie chimique. De plus de très nombreuses variantes peuvent être apportées qui permettent d'améliorer et la rapidité du procédé et la qualité du produit fini obtenu.

Le procédé selon l'invention permet aussi d'obtenir des films métallisés comportant une couche de cuivre ancrée dans le polymère pouvant être aussi faible que 1 micron tout en étant cohérente et résistante. Il sera distingué des procédés antérieurs par sa simplicité : pas de sensibilisation et d'activation du film, possibilité d'éviter la phase délicate de décapage superficiel de l'oxyde cuivreux inclus dans le substrat ; par son faible coût : pas d'emploi de sels de palladium chers ou de métaux pulvérulents nobles. De plus sa technologie est adaptée aux équipements existants. Il permet en outre d'obtenir par des méthodes simplifiées la réalisation de circuits imprimés, éventuellement à trous traversants dans des conditions économiques jamais trouvées jusqu'à présent.

Les possibilités de variantes sont très nombreuses, car à chaque étape du procédé il est possible de l'interrompre par exemple par un stockage du produit semi-fini pour le reprendre ultérieurement.

Selon la nature du polymère, selon le taux d'oxyde métallique inclus dans la masse du film, selon le traitement après réduction et en particulier selon la nature du métal déposé électrolytiquement ou par voie chimique, on obtiendra des films pouvant présenter de très nombreuses applications dans de très nombreux domaines comme par exemple la décoration, l'emballage ou les propriétés de la couche métallique comme étanchéité aux gaz, barrière au U.V., alimentarité ou soudabilité seront particulièrement appréciées. Les domaines de l'optique : surface réfléchissante, ou du son ainsi que de l'électricité ou de l'électronique où les films selon l'invention pourront être utilisés comme base de condensateur, de clavier, de circuiteries et d'autres applications, sont aussi concernés.

Les exemples suivants donnés à titre non limitatifs illustrent l'invention et montrent comment elle peut être mise en œuvre.

Exemples 1 à 6

On prépare un mélange constitué par 100 parties en poids d'un polyéthylèneglycol téréphtalate et par 100 parties en poids d'oxyde cuivreux. Le polyéthylèneglycol téréphtalate a une viscosité intrinsèque mesurée dans l'orthochlorophénol à 25 °C de 0,67 et a été réduit en poudre de granulométrie moyenne comprise entre 1 et 2 mm par broyage. L'oxyde cuivreux a une granulométrie moyenne inférieure à 2 microns.

Ce mélange après homogénéisation sur rouleau est séché 17 h à 160 °C sous vide de 2 mm de mercure puis extrudé dans un fondoir à piston. La température de fusion est de 285 à 288 °C. Les éléments filtrants sont constitués par une poudre métallique de 350 à 500 microns suivie d'une grille métallique de maille 100 mesh. La filière a une largeur de 22 mm et une épaisseur de 0,25 mm. La pression du piston est de 700 bars environ et le débit de la filière de 3 $cm^3$/mn. A la sortie de la filière le film extrudé tombe sur un rouleau récepteur chauffé à 88 °C et dont la vitesse linéaire périphérique varie de 0,4 à 3,8 m/mn. On recueille une bande souple de polymère dont les dimensions dépendent de la vitesse du rouleau.

On a ainsi obtenu des films ayant des dimensions suivantes :

| Exemples | Largeur en mm | Epaisseur en mm |
|---|---|---|
| 1 | 6 | 0,25 |
| 2 | 15 | 0,50 |
| 3 | 18 | 0,60 |

Pour l'exemple 3 le débit de la filière est supérieur à 3 $cm^3$/mn.

Le film obtenu à l'exemple 2 est étiré transversalement en utilisant un système de pinces dont l'une est mobile, l'ensemble étant placé dans un four entre 82 et 88 °C.

On a obtenu les films étirés suivants :

| Exemples | Taux d'étirage |
|---|---|
| 4 | 3,68 |
| 5 | 3,88 |
| 6 | 4,55 |

On appelle taux d'étirage le rapport entre la longueur du film entre les pinces après étirage et la longueur avant étirage.

Après étirage ces 3 échantillons subissent un traitement thermique de fixation à longueur constante pendant 5 secondes à 232 °C.

On améliore ainsi leur stabilité dimensionnelle.

On obtient des films sans défauts de planéité ou d'homogénéité.

Exemples 7 à 9

En suivant la même technique que dans les exemples précédents, on a préparé des films avec divers polymères et un taux de $Cu_2O$ de 45 % en poids.

Exemple 7 : Polyamide 6 : poly epsilon caprolactame ayant un point de fusion de 212 °C et une viscosité à 250 °C de 3 400 poises.

Exemple 8 : Copolyamide constitué en poids de 70 % d'epsilon caprolactame et de 30 % d'amide d'hexaméthylènediamine et d'acides dimères d'acides gras (marque Empol[R] 1010).

Exemple 9 : Polypropylène commercialisé sous la référence KF 6100 par la société Shell.

Ces trois essais sont résumés dans le tableau ci-après :

| Polymère | Conditions d'extrusion | | | Film obtenu en mm | |
|---|---|---|---|---|---|
| | Température °C | Pression au piston en bars | Débit à la filière en $cm^3/mn$ | Largeur | épaisseur |
| Exemple 7 | 275-285 | 630 | 4,5 | 6 | 0,35 |
| Exemple 8 | 250-260 | 530 | 4,5 | 12 | 0,30 |
| Exemple 9 | 290 | 530 | 2,6 | 17 | 0,25 |

Les films obtenus sont opaques, plans et sans défauts.

Exemples 10 à 12

Dans une variante du procédé décrit plus haut, on mélange les poudres de polymères de granulométrie comprise entre 3 et 4 mm et d'oxyde cuivreux $Cu_2O$ (en poids 50/50). On homogénéise ces mélanges de poudre sur une extrudeuse de laboratoire (commercialisée par la société Thoret ayant un diamètre de vis D de 20 mm et une longueur L = 20 D).

On utilise comme polymères :

A/ un polytéréphtalate d'éthylèneglycol (le même qu'à l'exemple 1).

B/ un polytéréphtalate de butylène 1,4-glycol.

Les conditions d'extrusion sont les suivantes :

| Polymère | Séchage préalable | Température d'extrusion en °C | Débit en kg/h |
|---|---|---|---|
| A | 17 h à 160°C | 285 | 1,0 |
| B | 3 h à 140°C puis 16 h à 80°C | 255 | 1,2 |

Les joncs extrudés sont solidifiés par refroidissement dans l'eau puis granulés.

Après un séchage sous vide de 17 h à 160 °C pour le polymère A et de 3 h à 160 °C pour le polymère B, les granulés sont introduits dans le fondoir à piston décrit à l'exemple 1.

Les conditions opératoires sont les suivantes :

| Exemple | Polymère | Température d'extrusion en °C | Débit à la filière en cm3/mn | Vitesse périphérique du rouleau en m/mn |
|---|---|---|---|---|
| 10 | A | 285 | 2,5 | 0,9 |
| 11 | A | 280 | 3,5 | 1,0 |
| 12 | B | 250 | 2,3 | 0,9 |

On obtient les films suivants présentant un bel aspect :

| Exemples | Largeur en mm | Epaisseur en mm |
|---|---|---|
| 10 | 12 | 0,22 |
| 11 | 14 | 0,25 |
| 12 | 14 | 0,17 |

Exemple 13

Le film de l'exemple 10 subit selon le processus décrit ci-avant un étirage transversal à 88 °C avec un taux de 3,0 puis un étirage longitudinal à 105 °C avec un taux de 3 puis un traitement thermique de fixation pendant 5 secondes à 230 °C.

Exemple 14

Le film de l'exemple 12 subit selon le processus décrit ci-avant des étirages transversaux à 82 °C. On effectue 3 étirages avec des taux de 3-3,8 et 4,75.

Exemples 15 et 16

On dispose d'une boudineuse de laboratoire commercialisée par la société Thoret équipée d'une vis de diamètre D = 25 mm et de longueur L = 20 D munie d'une pompe volumétrique à engrenage et d'une lèvre d'extrusion de dimensions transversales : 100 mm × 0,25 mm.

Le film extrudé est refroidi sur un tambour tournant dont la température est régulée par une circulation interne de fluide. A la sortie du tambour le film est enroulé sur une bobine.

On réalise des mélanges de polybutylène glycol téréphtalate (granulométrie 2 à 4 mm) et d'oxyde de cuivreux. On homogénéise sur rouleaux. On sèche 3 h à 140 °C puis on extrude sur l'appareil décrit ci-dessus.

| Ex. | Composition polymère/$Cu_2O$ en poids | Température sortie boudineuse | Température filière | Débit cm3/mn | Rouleau récepteur Temp. | Vitesse linéaire |
|---|---|---|---|---|---|---|
| 15 | 50/50 | 240°C | 238°C | 42 | 10°C | 3,1m/mn |
| 16 | 70/30 | 240°C | 238°C | 30 | 10°C | 2,6m/mn |

On obtient dans ces conditions des films ayant les dimensions suivantes :

| Exemples | Largeur en mm | Epaisseur en mm |
|---|---|---|
| 15 | 90 | 0,15 |
| 16 | 60 | 0,20 |

Les films sont sans défaut de surface et ont un bel aspect.

Exemples 17 à 19

Une partie des films en polyéthylène glycol téréphtalate résultant des essais 4 et 6 (mono étirés) et 13 (biétirés) sont enduits sur les deux faces par une solution aqueuse de borohydrure de potassium.

La composition de la solution réductrice est la suivante :

— 500 ml d'eau distillée
— 2,5 g de soude en pastille
— 5 g de sel de sodium de carboxyméthylcellulose (provenance Herculès type 7 MF, « medium viscosity », PM 250 000)
— 25 g de borohydrure de potassium
— 5 $cm^3$ d'agent mouillant (solution aqueuse à 1 % de Cémulsol[R] DB 311, agent de surface fabriqué et commercialisé par la Société Française d'Organo Synthèse S.F.O.S.).

La solution réductrice est laissée en contact 3 mn puis lavée à l'eau distillée tout en frottant la surface du film avec un feutre doux.

Après séchage les films ont une coloration cuivrée. Les résistances ohmiques entre deux points distants de 20 cm, mesurées avec des électrodes ponctuelles sont les suivantes :

exemple 17 : film provenant de l'exemple 4 : 37 à 40 ohms
exemple 18 : film provenant de l'exemple 6 : 25 à 30 ohms
exemple 19 : film provenant de l'exemple 13 : 9 à 15 ohms.

L'échantillon de référence 17 est alors placé à la cathode d'un bac d'électrolyse et maintenu tendu par une baguette de verre fixée à sa base. L'anode en cuivre est double, et située de part et d'autre du film. La solution d'électrolyte contient :

20 g/l de sulfate de cuivre ($SO_4Cu$, $5H_2O$)
0,5 ml/l d'acide sulfurique densité 1,8
5 ml/l de brillanteur RP 500 de (additif pour bains de cuivrage au sulfate acide, agent nivelant et de brillantage fabriqué par la Société Rhône-Poulenc). Le dépôt électrolytique léger est conduit pendant 10 mn sous 0,150 A/$dm^2$. Après rinçage et séchage du film cuivré, le dépôt est régulier, très brillant et très adhérent. Le dépôt est de l'ordre de 2 μm.

Il est à noter que le film réduit ne doit pas être immergé dans le bain acide hors tension sous peine de perdre très rapidement la conductibilité superficielle conférée par l'opération de réduction.

Exemples 20 à 23

Les films résultants des essais 3, 7, 8 et 9 sont décapés mécaniquement en surface. L'abrasif utilisé est de l'alumine en suspension dans l'eau, l'élément presseur étant un feutre. Cette opération a pour objet la mise au jour de la charge d'oxyde cuivreux par élimination de la pellicule de polymère pur recouvrant le film. Après décapage superficiel l'opération de réduction est conduite comme indiqué dans l'exemple 17. On obtient des films régulièrement cuivrés et conducteurs, le décapage de surface est moins régulier que dans les autres cas. L'opération doit être conduite avec une alumine plus fine. Il a été constaté qu'un fort refroidissement du film et une opération d'abrasion à sec conduisait à d'excellents résultats.

Exemples 24 à 27

Des échantillons de films résultant des exemples 3, 7 et 9 sont décapés mécaniquement en surface comme indiqué dans l'exemple 20 pour conduire respectivement aux films 24, 25, 26.

Un échantillon de film résultant de l'exemple 13, non décapé superficiellement est désigné par l'appellation 27.

Ces films sont perforés à l'aide d'un emporte-pièce produisant des trous de 1,2 mm de diamètre. Après perforation ces films sont réduits comme indiqué dans l'exemple 17, puis après rinçage, renforcé par un léger dépôt électrolytique selon les modalités indiquées dans l'exemple 17.

Il en résulte des films cuivrés de façon uniforme, avec un bel aspect de surface, les parois des trous sont également cuivrées, avec une jonction plan/trou, nette, assurant une très bonne continuité électrique.

Exemples 28 et 29

Les films de polybutylène glycol téréphtalate des exemples 15 et 16 sont décapés en surface par pressage des films sous légère tension sur un cylindre tournant, recouvert d'un feutre humecté par une suspension d'alumine dans l'eau.

Les films décapés sont désignés par l'appellation 28 et 29.

Sur une portion des films, un film de polytéréphtalate d'éthylène glycol, commercialisé sous la marque MYLAR[R] par la Société Du Pont de Nemours et portant l'image d'un tracé de circuiterie avec figuration de trous traversant par jonction recto/verso est positionné, et l'ensemble de l'empilement : « Mylar » — films décapés — feuille de papier est perforé à l'aide d'un emporte-pièce sur un sommier en carton dur.

Les deux films 28 et 29 ainsi perforés sont alors réduits selon le processus de l'exemple 17 puis soumis à un dépôt léger de cuivre dans un bain d'électrolyse très faiblement acide comme indiqué dans l'exemple 17 pour obtenir un dépôt continu de cuivre sur toute la surface des films y compris sur les parois des trous.

Les films cuivrés sont alors suspendus dans une hotte à flux laminaire et revêtus d'une couche de photorésist positif à base de résine formophénolique et d'un sensibilisateur dérivé du sulfo-5 naphtoquinodiazide-1,2, commercialisé sous la marque Maskoat[R] II de Rhône Poulenc, par pulvérisation. Après un préséchage à température ambiante, le séchage est réalisé en 30 mn en étuve à 90 °C.

Les films revêtus de photorésist sont alors repris entre les négatifs recto et verso du tracé à réaliser, l'ensemble étant soigneusement positionné puis insolé 140 secondes sous lampe U.V. de 2 000 W.

Le photorésist est développé sous agitation pendant 3 mn dans une solution aqueuse de développeur (solution aqueuse alcaline de phosphates et de silicates commercialisée sous la marque Maskoat[R] 13 par Rhône Poulenc), en solution aqueuse à 30 % en volume.

Les films sont alors soigneusement rincés et montés en cathode dans un bac de dépôt électrolytique de cuivre à double anode soluble. La composition du bain utilisé est la suivante :

— 75 g/l de sulfate de cuivre ($SO_4Cu$, $5H_2O$) (qualité de laboratoire)
— 180 g/l d'acide sulfurique concentré (densité = 1,83)
— 50 mg/l de chlorure de sodium
— 5 ml/l d'additif RP 500 de Rhône Poulenc.

L'électrolyse est conduite pendant 1 heure avec une densité de courant de 3 $A/dm^2$. Les films sont alors rincés, séchés, et le photorésist est éliminé par lavage à l'acétone.

Le dépôt électrolytique primaire, léger, situé sous le photorésist après développement est éliminé par immersion dans une solution aqueuse de chlorure ferrique à 10 % pendant 2 mn sous légère agitation. Après rinçage à l'eau distillée, le cuivre terni retrouve son brillant par immersion rapide dans une solution aqueuse d'acide sulfurique à 1 %.

Les circuits souples à jonctions électriques recto/verso sont rincés à l'eau distillée puis à l'alcool et séchés.

La zone, extérieure au circuit, d'amenée de courant pendant l'opération d'électrolyse est coupée. L'épaisseur du cuivre est d'environ 30 microns et la définition du tracé excellente.

Exemples 30 et 31

Les films obtenus aux exemples 10 et 12 sont trempés à température ambiante et pendant 5 minutes dans de la morpholine pure et dans de la pyridine pure. Ils sont ensuite rincés abondamment à l'eau. On fait subir alors aux échantillons le traitement de réduction comme indiqué à l'exemple 17. Après séchage les films ont une coloration cuivrée homogène et leur surface présente une résistance, mesurée entre deux points distants d'environ 20 cm, variant de 10 à 25 ohms.

**Revendications**

1. Procédé de métallisation de films souples, électriquement isolants en polymères filmogènes thermoplastiques ou ayant une phase thermoplastique, non thermodurcissables, caractérisé en ce qu'il comprend la succession d'étapes suivantes :

1. On prépare un mélange homogène du polymère filmogène avec de 10 à 70 % en poids par rapport à la composition totale d'oxyde cuivreux sous forme de particules, éventuellement en présence d'un solvant et de divers adjuvants.

2. On forme un film soit par extrusion soit par coulée à partir de ce mélange.

3. On met à jour, si besoin est, sur au moins une portion de la surface du film les grains d'oxyde cuivreux.

4. On réduit l'oxyde cuivreux en cuivre métallique par traitement avec un borohydrure d'au moins une portion de la surface du film pour la rendre conductrice de l'électricité.

5. On renforce ladite surface, éventuellement par voie électrolytique.

2. Procédé selon la revendication 1, caractérisé en ce que le polymère filmogène thermoplastique ou ayant une phase thermoplastique est choisi dans la famille constituée par les téréphtalates de polyéthylèneglycol, les téréphtalates de polybutylèneglycol, les polyamides, les polypropylènes, les polyphénylèneoxydes, les polysulfures, les polymères fluorés, les silicones, les polyacides parabaniques ou les mélanges de ces polymères ou leurs copolymères.

3. Procédé selon la revendication 1, caractérisé en ce que la mise à jour des grains d'oxyde cuivreux est au moins partiellement réalisée par un étirage du film.

4. Procédé selon la revendication 1, caractérisé en ce que les borohydrures utilisables sont choisis parmi les borohydrures alcalins non substitués et les borohydrures substitués dans lesquels au plus trois atomes d'hydrogène de l'ion borohydrure ont été remplacés par des substituants inertes dans les conditions de réduction.

5. Procédé selon la revendication 1, caractérisé en ce que l'agent réducteur est mis en contact avec le film sous forme d'une solution dans l'eau ou dans un mélange d'eau et d'un solvant polaire inerte dont la concentration, exprimée en pourcentage en poids d'hydrogène actif du borohydrure dans la solution, est comprise entre 0,05 et 1 %.

6. Films souples, susceptibles d'être obtenus selon le procédé de la revendication 1 et dont la couche de cuivre cohérente, après renforcement électrolytique, a une épaisseur supérieure ou égale à 1 micromètre.

7. Films souples, susceptibles d'être obtenus après l'étape 4 du procédé selon la revendication 1 et dont la partie réduite présente avant renforcement électrolytique une résistivité superficielle comprise entre 0,01 $\Omega/\square$ et $10^3$ $\Omega/\square$.

8. Procédé de fabrication de circuits imprimés, caractérisé en ce que le film conformé et étiré selon la revendication 3 est soumis aux opérations suivantes :

a) enduction par un photorésist du film réduit, éventuellement renforcé électrolytiquement,
b) développement du photorésist,
c) renforcement électrolytique direct,
d) élimination du photorésist,
e) gravure non sélective.

9. Procédé selon la revendication 8, caractérisé en ce qu'un dépôt électrolytique d'étain-plomb est réalisé après le renforcement électrolytique et avant l'élimination du photorésist.

10. Procédé de fabrication de circuits imprimés à trous traversants, caractérisé en ce que le film conformé et étiré selon la revendication 3 est perforé puis réduit puis renforcé électrolytiquement puis enduit par un photorésist qui est développé, puis renforcé électrolytiquement avant élimination du photorésist et gravure non sélective.

**Claims**

1. Process for metallizing electrically insulating flexible films of film-forming polymers which are thermoplastic or having a thermoplastic phase, which are not thermosetting, characterized in that it comprises the following sequence of stages :

1. A homogeneous mixture of the film-forming polymer is prepared with 10 to 70 % by weight, based on the total composition, of cuprous oxide in the form of particles, if desired in the presence of a solvent and of various adjuvants,

2. A film is formed either by extrusion or by casting using this mixture,

3. The grains of cuprous oxide are revealed, if need be, over at least a part of the film surface,

4. The cuprous oxide is reduced to metallic copper by treatment of at least a part of the film surface with a borohydride in order to make it electrically conductive,

5. The said surface is reinforced, electrolytically if appropriate.

2. Process according to Claim 1, characterized in that the film-forming polymer which is thermoplastic or having a thermoplastic phase is chosen from the group consisting of polyethyleneglycol terephthalates, polybutyleneglycol terephthalates, polyamides, polypropylenes, polyphenylene oxides, polysulphides, fluoropolymers, silicones, parabanic polyacids or mixtures of these polymers or their copolymers.

3. Process according to Claim 1, characterized in that the revealing of the grains of cuprous oxide is at least partially produced by drawing the film.

4. Process according to Claim 1, characterized in that the borohydrides which can be used are chosen from unsubstituted alkali metal borohydrides and substituted borohydrides in which at most three hydrogen atoms of the borohydride ion have been replaced by substituents which are inert under the conditions of reduction.

5. Process according to Claim 1, characterized in that the reducing agent is brought into contact with the film in the form of a solution in water or in a mixture of water and an inert polar solvent, the concentration of which, expressed as the percentage by weight of active hydrogen of the borohydride in the solution, is between 0.05 and 1 %.

6. Flexible films capable of being obtained according to the process of Claim 1 and in which, after electrolytic reinforcement, the cohesive copper layer has a thickness greater than or equal to 1 micrometre.

7. Flexible films capable of being obtained after stage 4 of the process according to Claim 1 and in which, before electrolytic reinforcement, the reduced part has a surface resistivity of between 0.01 Ω/□ and $10^3$ Ω/□.

8. Process for the manufacture of printed circuits, characterized in that the film formed and drawn according to Claim 3 is subjected to the following operations:

a) coating of the reduced film, if appropriate electrolytically reinforced, with a photoresist,

b) development of the photoresist,

c) direct electrolytic reinforcement,

d) removal of the photoresist,

e) nonselective etching.

9. Process according to Claim 8, characterized in that a tin-lead electrolytic deposit is produced after the electrolytic reinforcement and before the removal of the photoresist.

10. Process for the manufacture of printed circuits with feedthroughs, characterized in that the film formed and drawn according to Claim 3 is perforated and then reduced then reinforced electrolytically then coated with a photoresist which is developed, and then reinforced electrolytically, before removal of the photoresist and nonselective etching.

**Patentansprüche**

1. Verfahren zum Metallisieren von biegsamen, elektrisch isolierenden Folien aus filmbildenden thermoplastischen Polymeren oder die eine thermoplastische Phase enthalten und nicht in der Wärme härtbar sind, dadurch gekennzeichnet, daß es die aufeinander folgenden Stufen umfaßt:

1) man stellt ein homogenes Gemisch aus dem filmbildenden Polymer mit 10 bis 70 Gew.-%, bezogen auf die Gesamtmasse, feinteiligem Kupfer-1-oxid her, gegebenenfalls in Gegenwart eines Lösungsmittels und verschiedener Zusätze;

2) man stellt aus dem Gemisch durch Extrusion oder durch Gießen eine Folie her;

3) man legt, soweit erforderlich, auf mindestens einem Teil der Oberfläche der Folie die Körner von Kupfer-1-oxid frei;

4) man reduziert auf mindestens einem Teil der Oberfläche der Folie das Kupfer-1-oxid durch Behandlung mit einem Borhydrid zu metallischem Kupfer, um es elektrisch leitfähig zu machen;

5) man verstärkt die erwähnte Oberfläche gegebenenfalls elektrolytisch.

2. Verfahren nach Anspruch 1, dadurch gekennzeichnet, daß das filmbildende thermoplastische Polymer oder das eine thermoplastische Phase enthaltende ausgewählt ist aus der Gruppe bestehend aus den Polyäthylenglykolterephtalaten, den Polybutylenglykolterephtalaten, den Polyamiden, den Polypropylenen, den Polyphenylenoxiden, den Polysulfiden, den fluorierten Polymeren, den Polyparabansäuren oder den Gemischen dieser Polymere oder deren Copolymeren.

3. Verfahren nach Anspruch 1, dadurch gekennzeichnet, daß das Freilegen der Kupfer-1-oxid-Körner zumindest teilweise durch Strecken der Folie durchgeführt wird.

4. Verfahren nach Anspruch 1, dadurch gekennzeichnet, daß die anwendbaren Borhydride ausgewählt sind aus den nichtsubstituierten Alkaliborhydriden und den substituierten Borhydriden, bei denen höchstens 3 Wasserstoffatome des Borhydridions durch unter den Reduktionsbedingungen inerte

Substituenten ersetzt sind.

5. Verfahren nach Anspruch 1, dadurch gekennzeichnet, daß das Reduktionsmittel mit der Folie in Kontakt gebracht wird in Form einer Lösung in Wasser oder in einem Gemisch aus Wasser und einem inerten polaren Lösungsmittel, wobei die Konzentration, angegeben in Gew.-% aktivem Wasserstoff des Borhydrids in der Lösung, zwischen 0,05 und 1 % liegt.

6. Biegsame Folien, die erhalten werden können nach demem Verfahren nach Anspruch 1, bei denen die zusammenhängende Kupferschicht nach der elektrolytischen Verstärkung eine Dicke $\geq 1\ \mu m$ besitzt.

7. Biegsame Folien, die nach der Stufe 4) des Verfahrens nach Anspruch 1 erhalten werden können und bei denen der reduzierte Anteil vor der elektrolytischen Verstärkung einen Oberflächenwiderstand zwischen 0,01 $\Omega/\square$ und $10^3\ \Omega/\square$ aufweist.

8. Verfahren zur Herstellung gedruckter Schaltungen, dadurch gekennzeichnet, daß die Folie geformt und gestreckt nach Anspruch 3 den folgenden Operationen unterworfen wird :

a) Überziehen der reduzierten gegebenenfalls elektrolytisch verstärkten Folie mit einem Photoresist (lack) ;

b) Entwickeln des Photoresist (lacks) ;

c) direktes elektrolytisches Verstärken ;

d) Entfernung des Photoresist (lacks) ;

e) nicht-selektives Ätzen.

9. Verfahren nach Anspruch 8, dadurch gekennzeichnet, daß eine elektrolytische Abscheidung von Zinn-Blei nach der elektrolytischen Verstärkung und vor der Entfernung des Photoresists durchgeführt wird.

10. Verfahren zur Herstellung gedruckter Schaltungen mit durchgehenden Öffnungen dadurch gekennzeichnet, daß die Folie hergestellt und gestreckt nach Anspruch 3 gelocht, anschließend reduziert, anschließend elektrolytisch verstärkt, anschließend mit einem Photoresist, das entwickelt wird, überzogen, anschließend vor der Eliminierung des Photoresist und nicht selektivem Ätzen elektrolytisch verstärkt wird.